(19) Europäisches Patentamt

European Patent Office

Office européen des brevets

(11) Veröffentlichungsnummer: **0 258 530**
**A2**

(12) **EUROPÄISCHE PATENTANMELDUNG**

(21) Anmeldenummer: **87105587.7**

(22) Anmeldetag: **15.04.87**

(51) Int. Cl.⁴: **H01L 27/14**

(30) Priorität: **01.09.86 DE 3629681**

(43) Veröffentlichungstag der Anmeldung:
**09.03.88 Patentblatt 88/10**

(84) Benannte Vertragsstaaten:
**DE FR GB IT**

(71) Anmelder: **Licentia Patent-Verwaltungs-GmbH**
**Theodor-Stern-Kai 1**
**D-6000 Frankfurt/Main 70(DE)**

(72) Erfinder: **Dämbkes, Heinrich, Dr.-Ing.**
**Stäudlenweg 29**
**D-7900 Ulm(DE)**
Erfinder: **König, Ulf, Dr.-Ing.**
**Scultetusweg 2**
**D-7900 Ulm(DE)**

(74) Vertreter: **Schulze, Harald Rudolf, Dipl.-Ing. et al**
**Licentia Patent-Verwaltungs-GmbH**
**Theodor-Stern-Kai 1**
**D-6000 Frankfurt/Main 70(DE)**

(54) **Photoempfänger.**

㋷ Die Erfindung betrifft einen monolithisch integrierten Photoempfänger aus zumindest einer PIN-Diode und mindestens einem HEMT. Der Photoempfänger ist für einen in der Lichtleitfasertechnik nutzbaren Wellenlängenbereich von 0,8 bis 1,55µm geeignet. Die Heterostruktur-Halbleiterschichtenfolge mit invertiert aufgebauter PIN-Diode ist so gewählt, daß im HEMT keine störende laterale Leitfähigkeit auftritt.

EP 0 258 530 A2

## "Photoempfänger"

Die Erfindung betrifft einen monolithisch integrierten Photoempfänger nach dem Oberbegriff des Patentanspruchs 1.

Photoempfänger gemäß der Erfindung sind für Meß-oder Nachrichtenübertragungssysteme geeignet. Vorbekannte Lösungen von monolithisch integrierten optoelektronischen Empfängerschaltungen sind beispielsweise eine Kombination aus einer PIN-Diode und einem JFET(Junction Field Effect Transistor) auf InGaAs Basis(Lit.: R.E.Nahory, R.F.Leheny, Proc.Soc.Photo-Optical Instrum. Eng. 272(1981), S.32-35) oder eine Kombination aus einer PIN-Diode und einem Heterobipolartransistor aus InP/InGaAsp-Verbindungen. Diese optoelektronischen Empfängerschaltungen haben jedoch den Nachteil, daß sie eine geringe Schaltgeschwindigkeit und hohe Rauschzahlen besitzen.

Die Erfindung liegt daher die Aufgabe zugrunde, einen schnellschaltenden und rauscharmen monolithisch integrierten Photoempfänger anzugeben, der insbesondere für einen für die Lichtleitfasertechnik nützlichen Wellenlängenbereich $\lambda$ von vorzugsweise $0,8 \leq \lambda \leq 1,55\mu m$ geeignet ist.

Diese Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen entnehmbar.

Der monolithisch integrierte Photoempfänger gemäß der Erfindung hat den Vorteil, daß ein - schnellschaltender Feldeffekttransistor, dessen Grenzfrequenz im GHz-Bereich liegt, der einen hochohmigen Eingangswiderstand hat und sehr rauscharm ist, mit einem optischen Detektor mit hohem Quantenwirkungsgrad und geringem Rauschen kombiniert werden kann.

Die Erfindung wird im folgenden anhand von Ausführungsbeispielen näher erläutert unter Bezugnahme auf schematische Zeichnungen.

Fig. 1 Fig. 3 Fig. 4 zeigen einen monolithisch integrierten Photoempfänger bestehend aus einer PIN-Diode 14 und einem HEMT (High Electron Mobility Transistor) 15 in Mesabauweise.

Fig. 2 zeigt einen monolithisch integrierten Photoempfänger bestehend aus einer PIN-Diode-(14) und einem HEMT (15), die planar angeordnet sind.

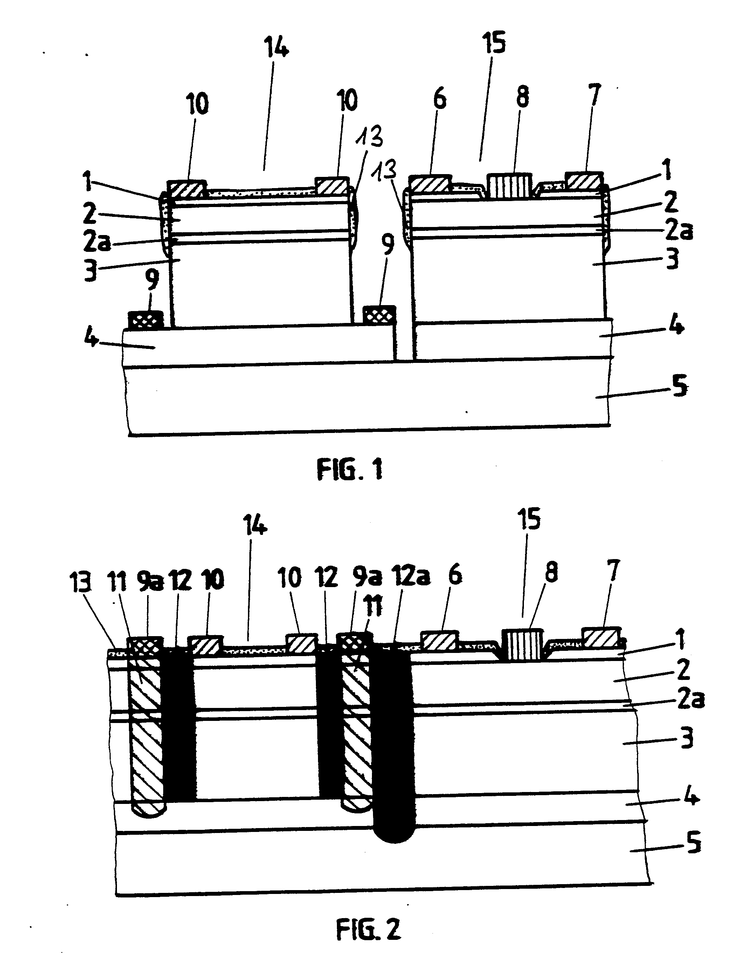

Im Ausführungsbeispiel gemäß Fig. 1 ist auf einem beispielsweise halbisolierenden Substrat 5 aus InP eine Heterostruktur-Halbleiterschichtenfolge aus

-einer p-dotierten Halbleiterschicht 4 aus InP oder InGaAsP mit einer Ladungsträgerkonzentration von $10^{17}$-$5.10^{18}$ cm$^{-3}$ und einer Schichtdicke von 10-500nm,

-einer n$^{---}$-dotierten Halbleiterschicht 3 aus InGaAs mit einer Ladungsträgerkonzentration von $10^{14}$-$10^{16}$ cm$^{-3}$ und einer Schichtdicke von 1,5-2,5$\mu m$,

-einer undotierten Halbleiterschicht 2a aus InP oder InGaAsP oder InAlAs und einer Schichtdicke von ungefähr 5nm,

-einer n$^+$-dotierten Halbleiterschicht 2 aus InP oder InGaAsP oder InAlAs mit einer Ladungsträgerkonzentration von $10^{17}$-$2 \bullet 10^{18}$ cm$^{-3}$ und einer Schichtdicke von 20-100nm,

-einer n$^{++}$-dotierten Halbleiterschicht 1 aus InGaAs oder InGaAsP mit einer Ladungsträgerkonzentration von $10^{17}$-$6.10^{18}$ cm$^{-3}$ und einer Schichtdicke von 0-100nm aufgewachsen.

Besteht das Substrat 5 beispielsweise aus halbisolierendem GaAs, so ist die p-dotierte Halbleiterschicht 4 vorzugsweise aus GaAs oder GaAlAs, die n$^{--}$-dotierte Halbleiter schicht 3 aus GaAs oder $In_xGa_{1-x}$ As (x < 0,1), die undotierte Halbleiterschicht 2a aus GaAs oder GaAlAs, die n$^+$-dotierte Halbleiterschicht 2 aus GaAlAs und die n$^{++}$-dotierte Halbleiterschicht 1 aus GaAs aufgebaut. Die Dotierkonzentrationen und Schichtdicken entsprechen dem oben beschriebenen Ausführungsbeispiel.

Die " + "-oder "-" Bezeichnung bei der Dotierkonzentration gibt die Stärke der Dotierung an: " + " bedeutet starke und "-" schwache Dotierung.

Alternativ zu der oben beschriebenen Heterostruktur-Halbleiterschichtenfolge kann beispielsweise eine Halbleiterschichtenfolge erzeugt werden,

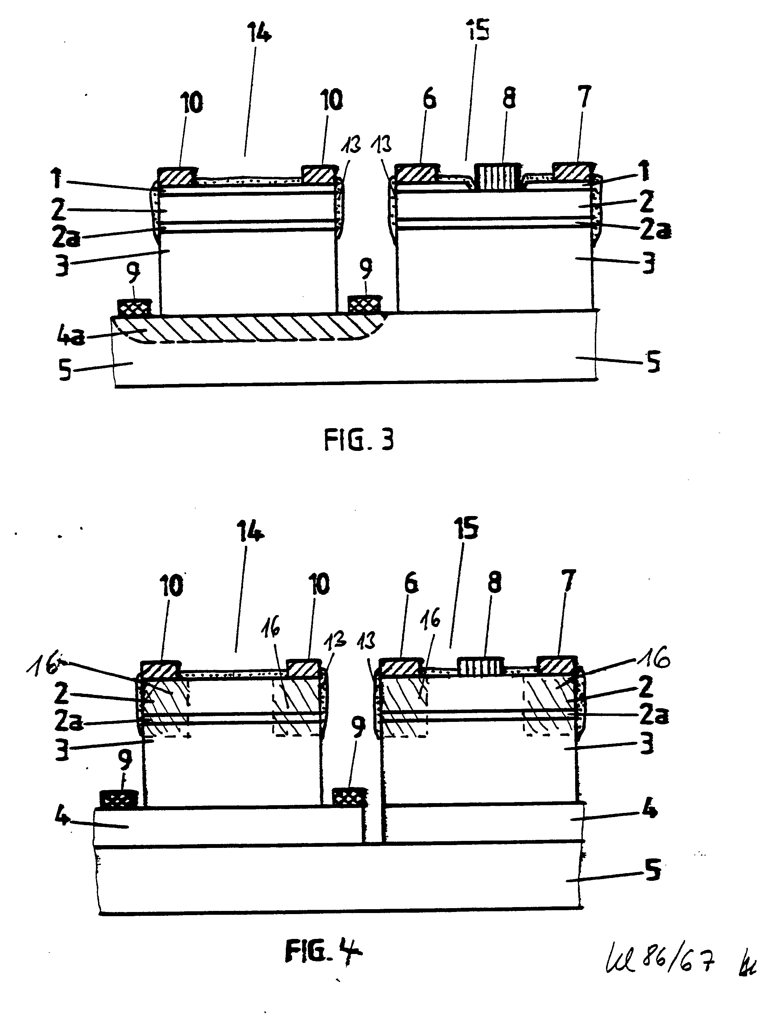

-die anstatt der p-dotierten Halbleiterschicht 4 lediglich im Bereich der PIN-Diode 14 eine in das Substrat 5 selektive p-implantierte Zone 4a mit einer Ladungsträgerkonzentration von $10^{17}$-$10^{18}$ cm$^3$ und einer Tiefe von ungefähr 0,5$\mu m$ besitzt (Fig. 3) und/oder

-in die anstatt der p-dotierten Halbleiterschicht 4, der n$^+$-dotierten Halbleiterschicht 2 und der undotierten Halbleiterschicht 2a ein Übergitter aus gitterangepaßten materialien wie z.B. InAlAs/InGaAs, InAlAs/InGaAsP, InP/InGaAs, InP/InGaAsP bzw. InP/InAlAs oder aus gitterfehlangepaßten Materialien, deren Schichtdicken jeweils unterhalb einer kritischen Schichtdicke liegen, wie z.B. GaP, GaA, InAs, InAlAs oder InAlAsP, eingebaut ist.

Als Dotierstoffe für p-Dotierung werden beispielsweise Be, Mg oder Zn und für n-Dotierung Si, S oder Sn verwendet. Die durch Ionenimplantation entstandenen Schäden im Kristall werden durch einen anschließenden Temperprozeß ausgeheilt.

In den Ausführungsbeispielen gemäß Fig. 1 und Fig. 3 ist ein Photoempfänger aus einer PIN-Diode 14 und einem HEMT (High Electron Mobility Transistor) 15 in Mesabauweise aufgebaut. Source- und Drain-Anschluß 6, 7 des HEMT 15 sind auf der $n^{++}$-dotierten Halbleiterschicht 1 aufgebracht. Die Anschlüsse 6, 7 sind sperrfreie ohmsche Kontakte, z.B. aus einer Au/Ge-Legierung. Im Bereich der Steuelektrode 8 des HEMT 15 ist die $n^{++}$-dotierte Halbleiterschicht 1 weggeätzt und die Steuerelektrode 8 kontaktiert die $n^+$-dotierte Halbleiterschicht 2. Die Steuerung der Raumladungszone, die sich unterhalb der Elektrode 8 ausbildet, erfolgt über einen sperrenden metallischen Kontakt. Zur Verbesserung der Sperreigenschaften der Steuerelektrode 8 ist es vorteilhaft, die $n^+$-Dotierung der Halbleiterschicht 2 in vertikaler Richtung zu variieren, derart, daß die Dotierkonzentration zur $n^{++}$-dotierten Halbleiterschicht 1 auf Null abnimmt.

Die Elektroden 9, 10 der PIN-Diode 14 in Mesabauweise sind beispielsweise ringförmig angeordnet, wobei die erste Elektrode 10 die $n^{++}$-dotierte Halbleiterschicht 1 und die zweite Elektrode 9 entweder die p-dotierte Halbleiterschicht 4 oder die in das Substrat 5-implantierte Zone 4a kontaktiert. Die Elektroden 9, 10 der PIN-Diode 14 sind sperrfreie metallische Kontakte und sind beispielsweise aus einer Au/Ge-oder Au/Zn-Legierung hergestellt.

Zur Verbesserung der Kontaktierung der $n^{---}$-dotierten Halbleiterschicht 3 der PIN-Diode 14 bzw. des sich zwischen der undotierten Halbleiterschicht 2a und der $n^{---}$-dotierten Halbleiterschicht 3 im HEMT 15 ausbildenden Elektronengases können senkrecht zu den Halbleiterschichten $n^{++}$-dotierte Gebiete 16 implantiert werden. Die $n^{++}$-dotierte Halbleiterschicht 1 kann dadurch entfallen (Fig. 4). Die Dotierkonzentration der $n^{++}$-implantierten Gebiete 16 beträgt $10^{16}$-$10^{18}$ Ladungsträger pro $cm^3$.

Das Ausführungsbeispiel gemäß Fig. 2 besitzt die gleiche Heterostruktur-Schichtenfolge wie das Ausführungsbeispiel gemäß Fig. 1. Jedoch sind PIN-Diode 14 und HEMT 15 planar ausgebildet. Für die planare Bauform ist auch eine Halbleiterschichtenfolge gemäß Fig.3 oder Fig. 4 geeignet. Die elektrischen Anschlüsse des HEMT 15 und der PIN-Diode 14 sind in einer Ebene angeordnet. Die Kontaktierung der zweiten Elektrode 9a der PIN-Diode 14 mit der p-leitenden Halbleiterschicht 4 bzw. mit der in das Substrat 5 p-implantierten Zone 4a erfolgt durch ein senkrecht zu den Halbleiterschichten 1 bis 4 p-implantiertes Gebiet 11, das eine Dotierkonzentration von mehr als $10^{17}$ positiven Ladungsträgern pro $cm^3$ besitzt.

Ein erstes Isolationsgebiet 12, das senkrecht zu den Halbleiterschichten 1, 2, 2a, 3 verläuft, trennt die Elektroden 9a, 10 der PIN-Diode 14. Ein zweites Isolationsge biet 12a, das senkrecht zu der Halbleiterschichtenfolge verläuft und bis ins Substrat 5 reicht, grenzt PIN-Diode 14 und HEMT 15 voneinander ab.

Die Isolationsgebiete 12, 12a werden entweder durch Ionenimplantation, z.B. mit Fe, oder durch geeignete Ätz-und anschließende Auffülltechniken, z.B. mit Polyimid, hergestellt.

In den Ausführungsbeispielen ist vorteilhafterweise auf die $n^{++}$-dotierte Halbleiterschicht 1 oder die $n^+$-dotierte Halbleiterschicht 2 eine Passivierungs-und Antireflexionsschicht 13, z.B. aus $SiO_2$, aufgetragen, in der sich Fenster für die elektrischen Kontakte befinden.

Die elektrischen Kontakte der PIN-Diode 14 und des HEMT 15 können beispielsweise über metallische Leiterbahnen in geeigneter Weise miteinander verbunden werden.

Vorteilhafterweise wird die Kompatibilität von PIN-Diode 14 und HEMT 15 zur Herstellung eines erfindungsgemäßen Photoempfängers dadurch erreicht, daß die $n^{---}$-dotierte Halbleiterschicht 3
-als Absorptionsschicht der PIN-Diode 14 ausgebildet ist,
-eine geeignete Schichtdicke von ungefähr 2μm besitzt, so daß die Photonen vollständig absorbiert werden,
-einen geringeren Bandabstand als die darauf aufgewachsenen Halbleiterschichten 2, 2a besitzt, damit sich im HEMT 14 in der $n^{---}$-dotierten Halbleiter schicht 3 ein Potentialtopf ausbildet, in dem sich die Elektronen quasi-frei bewegen können.

Die p-dotierte Halbleiterschicht 4 oder die Übergitterstruktur haben den Vorteil, daß
-sie als Pufferschicht zwischen Substrat 5 und den folgenden Halbleiterschichten wirken und Kristalldefekte im wesentlichen an der Grenzfläche Substrat/Pufferschicht lokalisiert sind,
-im HEMT 15 keine störende laterale Leitfähigkeit auftritt.

Monolithisch integrierte Photoempfänger gemäß der Erfindung, lassen sich mit Hilfe der Molekularstrahl-Epitaxie oder der chemischen Gasphasen-Epitaxie aus metallorganischen Verbindungen herstellen.

Die Erfindung ist nicht auf die beschriebenen Ausführungsbeispiele beschränkt, sondern sinngemäß auf weitere Materialkombinationen anwendbar.

## Ansprüche

1. Monolithisch integrierter Photoempfänger, bestehend aus einem Substrat, auf dem eine Halbleiterschichtenfolge aufgebracht ist, die zumindest eine PIN-Diode, sowie mindestens einen Feldeffekttransistor, insbesondere einen HEMT, enthält, **dadurch gekennzeichnet,**
-daß PIN-Diode (14) und HEMT (15) aus einer gleichen Heterostruktur-Halbleiterschichtenfolge hergestellt sind,
- daß auf einem Substrat (5) mindestens eine p-dotierte Halbleiterschicht (4) aufgewachsen ist, und
-daß die p-dotierte Halbleiterscicht (4) gleichzeitig als invertiert angeordnete p-Kontaktschicht der PIN-Diode (14) und als Pufferschicht ausgebildet ist.

2. Monolithisch integrierter Photoempfänger nach Anspruch 1, dadurch gekennzeichnet, daß die Halbleitermaterialien so gewählt sind, daß der Wellenlängenbereich $\lambda$ des Photoempfängers zwischen $0,8 \leq \lambda \leq 1.55 \mu m$ liegt.

3. Monolithisch integrierter Photoempfänger nach einem der vorhergehenden Ansprüche, dadurch gekennzeichnet, daß auf die p-dotierte Halbleiterschicht (4) eine Halbleiterschichtenfolge aus einer $n^{--}$-dotierten Halbleiterschicht (3), einer undotierten Halbleiterschicht (2a), einer $n^+$-dotierten Halbleiterschicht (2) und einer $n^{++}$-dotierten Halbleiterschicht (1) aufgewachsen ist.

4. Monolithisch integrierter Photoempfänger nach einem der vorhergehenden Ansprüche, dadurch gekennzeichnet, daß die undotierte Halbleiterschicht (2a) und die $n^+$-dotierte Halbleiterschicht (2) als Übergitter ausgebildet sind.

5. Monolithisch integrierter Photoempfänger nach einem der vorhergehenden Ansprüche, dadurch gekennzeichnet,
-daß die Steuerelektrode (8) des HEMT (15) mit der $n^+$-dotierten Halbleiterschicht (2) kontaktiert ist und
-daß Source-und Drain-Anschluß (6, 7) des HEMT (15) auf der $n^{++}$-dotierten Halbleiterschicht (1) aufgebracht sind.

6. Monolithisch integrierter Photoempfänger nach einem der vorhergehenden Ansprüche, dadurch gekennzeichnet, daß die erste Elektrode (10) der PIN-Diode (14) die $n^{++}$-dotierte Halbleiterschicht (1) und die zweite Elektrode (9) die p-dotierte Halbleiterschicht (4) kontaktiert.

7. Monolithisch integrierter Photoempfänger nach einem der Ansprüche 1 bis 4, dadurch gekennzeichnet,
-daß die $n^{++}$-dotierte Halbleiterschicht (1) entfernt ist, und
-daß die n-Kontaktierung der elektrischen Anschlüsse (6, 7, 10) der PIN-Diode (14) und des HEMT (15) über $n^{++}$-implantierte Gebiete (16) erfolgt, die senkrecht zu den Halbleiterschichten (2, 2a) verlaufen und bis in die $n^{--}$-dotierte Halbleiterschicht (3) reichen (Fig. 4).

8. Monolithisch integrierter Photoempfänger nach einem der vorhergehenden Ansprüche, dadurch gekennzeichnet, daß PIN-Diode (14) und HEMT (15) planar angeordnet sind und durch ein zweites Ioslationsgebiet (12a), das senkrecht zu den Halbleiterschichten verläuft und bis ins Substrat (5) reicht, getrennt sind (Fig. 2).

9. Monolithisch integrierter Photoempfänger nach einem der vorhergehenden Ansprüche, dadurch gekennzeichnet,
-daß die zweite Elektrode (9a) der PIN-Diode (14) durch ein p-implantiertes Gebiet (11) die p-dotierte Halbleiterschicht (4) kontaktiert, und
-daß die Elektroden (9a, 10) der PIN-Diode (14) durch ein erstes Isolationsgebiet (12) abgegrenzt sind, das senkrecht zu den Halbleiterschichten (1, 2, 2a) verläuft und bis in die $n^{--}$-dotierte Halbleiterschicht (3) reicht.

10. Monolithisch integrierter Photoempfänger nach einem der Ansprüche 1 bis 7, dadurch gekennzeichnet, daß PIN-Diode (14) und HEMT (15) in Mesabauweise ausgebildet sind (Fig. 1).

11. Monolithisch integrierter Photoempfänger nach einem der vorhergehenden Ansprüche, dadurch gekennzeichnet, daß anstatt der p-dotierten Halbleiterschicht (4) im Bereich der PIN-Diode (14) eine p-implantierte Zone (4a) im Substrat (5) erzeugt wird (Fig. 3).

FIG. 1

FIG. 2

0 258 530

UL 86/67

FIG. 3

FIG. 4